Europäisches Patentamt

(19) European Patent Office

Office européen des brevets

(11) Publication number: **0 271 331**
**A2**

(12) **EUROPEAN PATENT APPLICATION**

(21) Application number: 87310829.4

(22) Date of filing: 09.12.87

(51) Int. Cl.⁴: **H 03 K 19/094**
H 03 K 19/017

(30) Priority: 09.12.86 JP 292770/86

(43) Date of publication of application:
15.06.88 Bulletin 88/24

(84) Designated Contracting States: DE FR GB

(71) Applicant: **KABUSHIKI KAISHA TOSHIBA**
72, Horikawa-cho Saiwai-ku
Kawasaki-shi Kanagawa-ken 210 (JP)

(72) Inventor: Takayasu, Sakurai
c/o Kabushiki Kaisha Toshiba 1-1, Shibaura 1-chome
Minato-ku Tokyo (JP)

Kazutaka, Nogami
c/o Kabushiki Kaisha Toshiba 1-1, Shibaura 1-chome
Minato-ku Tokyo (JP)

(74) Representative: Sturt, Clifford Mark et al
MARKS & CLERK 57-60 Lincoln's Inn Fields
London WC2A 3LS (GB)

(54) **Semiconductor integrated circuit.**

(57) This invention provides a semiconductor integrated circuit to be connected between the high and low potentials ($V_{DD}$, $V_{SS}$) of a power source, comprising, a data output buffer means (13) having an output node (N3) for outputting data, and a voltage limiting circuit means (14) for limiting the potential of the output node (N3) to less than the high potential level.

Fig. 5

EP 0 271 331 A2

**Description**

SEMICONDUCTOR INTEGRATED CIRCUIT

This invention relates to semiconductor integrated circuits. In particular, it relates to output circuits which use MOS transistors (insulated gate transistors).

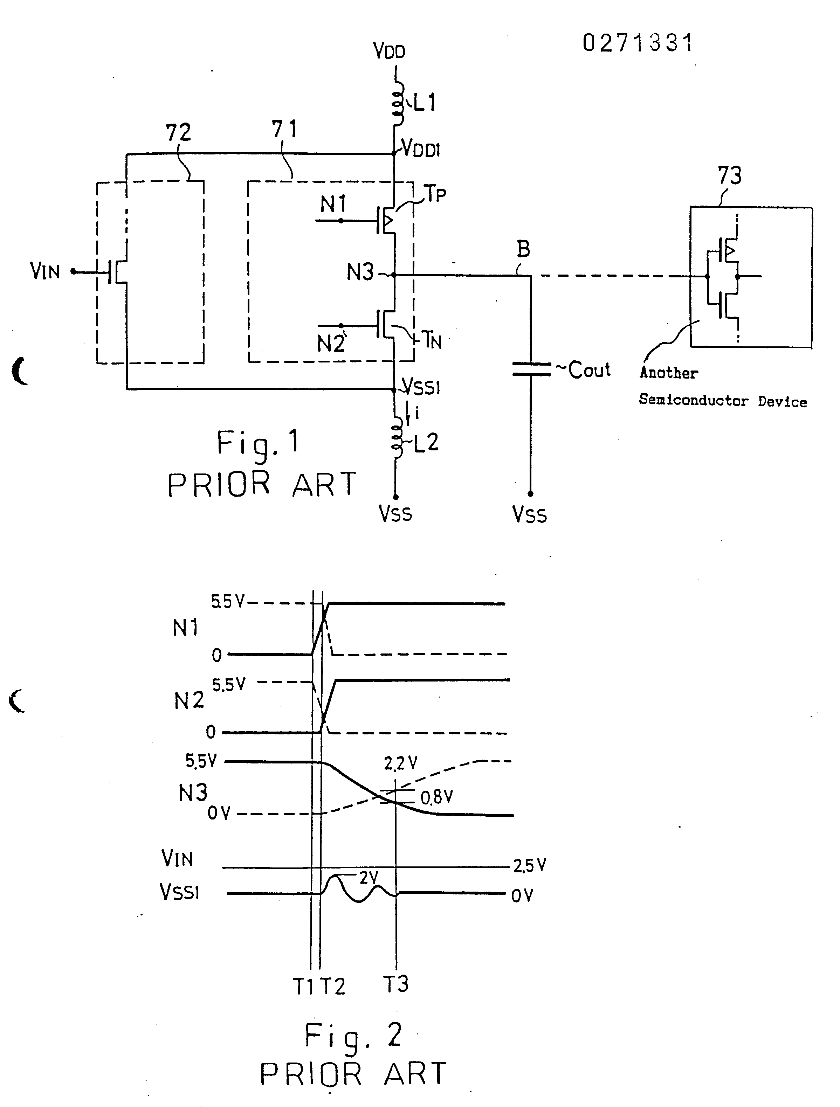

The output circuits of conventional semiconductor integrated circuits are constructed as shown in Figure 1. That is to say, a final state output buffer 71 is formed by connecting a P-channel transistor $T_P$ and an N-channel transistor $T_N$ in series between the chip internal $V_{DD1}$ power source node of the high potential side and $V_{SS1}$ power source node of the low potential (the earth potential) side. A different drive signal is applied to each of these transistors' gates (nodes N1 and N2). $C_{out}$ designates an output capacitance connected between output wire B, which is connected to output node N3 (the mutual point of connection of the drains of transistors $T_P$ and $T_N$), and the earth terminal. L1 designates an inductor between $V_{DD1}$ power source node and the chip external $V_{DD}$ power source. L2 designates an inductor between $V_{SS1}$ power source node and the chip external $V_{SS}$ power source. Rference numberal 72 designates the input circuit. Also, 73 is another semiconductor device to which the output signal from the output terminal of this semiconductor integrated circuit is inputted.

The operation of this output circuit is explained with reference to Figure 2. At time T1, the output data is taken as having arrived at final state output buffer 71. First, the case of the output of output node N3 being driven from high logic level "1" to low logic level "0", as shown by the solid line in Figure 2, is explained. At time T1, P-channel transistor $T_P$ is turned OFF, and at time T2, N-channel transistor $T_N$ is turned ON. This can be achieved by slightly staggering the timings of the driving wave-forms on nodes N1 and N2. If the timings of these tow driving wave-forms match, a time will occur when both transistors $T_P$ and $T_N$ are ON at the same time, and this is undesirable since, at that time, a very large through current will flow between the $V_{DD}$ power source and the $V_{SS}$ power source through both transistors $T_P$ and $T_N$. Then their low-consumption power characteristic will be lost. When node N2 becomes "1" and N-channel transistor $T_N$ is ON, output node N3 is drawn down towards "0". Then, at time T3, when the output potential has become 0.8V, it is recognised by the other semiconductor device 73 that "0" is outputted. Consequently, the period from the integrated circuit having been accessed to time T3 is taken as the delay time of the integrated circuit. In TTL- (Transistor-Transistor-Logic) compatible specifications, the 0.8V mentioned above is the maximum voltage which the integrated circuit ensures as the low logic level output and is called $V_{OL}$.

Next, the case when the output is driven from "0" to "1", as shown by the dotted line in Figure 2, is explained. At time T1, N-channel transistor $T_N$ is turned OFF, and at time $T_2$, P-channel transistor $T_P$ is turned ON. Output node N3 starts moving towards "1" from time T2, and at time T3 when the potential of the output has become 2.2V. the output is recognised as being "1" by the other semiconductor device 73. Here, in TTL-compatible specifications, this 2.2V is the minimum voltage which the integrated circuit ensures as the high logic level output is called $V_{OH}$. Then, even after the potential of this output has reached 2.2V. it rises towards the power source voltage $V_{DD}$. This $V_{DD}$ voltage is normally permitted up to a maximum of 5.5V in TTL-compatible specifications. The reason for raising the output to the $V_{DD}$ voltage in this way is in order not to create a through path between the power sources in the output section of the other semiconductor device 73 when the integrated circuit is on stand-by. The aim is to achieve a low-consumption power characteristic for a system using the integrated circuit and the other semiconductor device 73. Normally, no very high speed is required in the operation of raising this output from the $V_{OH}$ to the $V_{DD}$ voltage.

As can be seen from the above explanation, when the output changes from "1" to "0", the 4.7V variation of the output voltage from 5.5V to 0.8V must be carried out between times T2 and T3. As opposed to this, when the output changes from "0" to "1", it is sufficient only to change the output voltage by 2.2V from 0V to 2.2V between timesT2 and T3. Consequently, the voltage must be varied more than twice as fast when the output is "0" as when it is "1". For this reason, it is necessary to cause a high-speed discharge of the charge from capacitance $C_{out}$ which is attached to output wire B. That is to say, it is necessary to pass a very large current i via N-channel transistor $T_N$. In this case, since the current in output wire B and the $V_{SS}$ power source wire is zero before time T2, the variation of discharge current i with time, di/dt, is naturally also large.

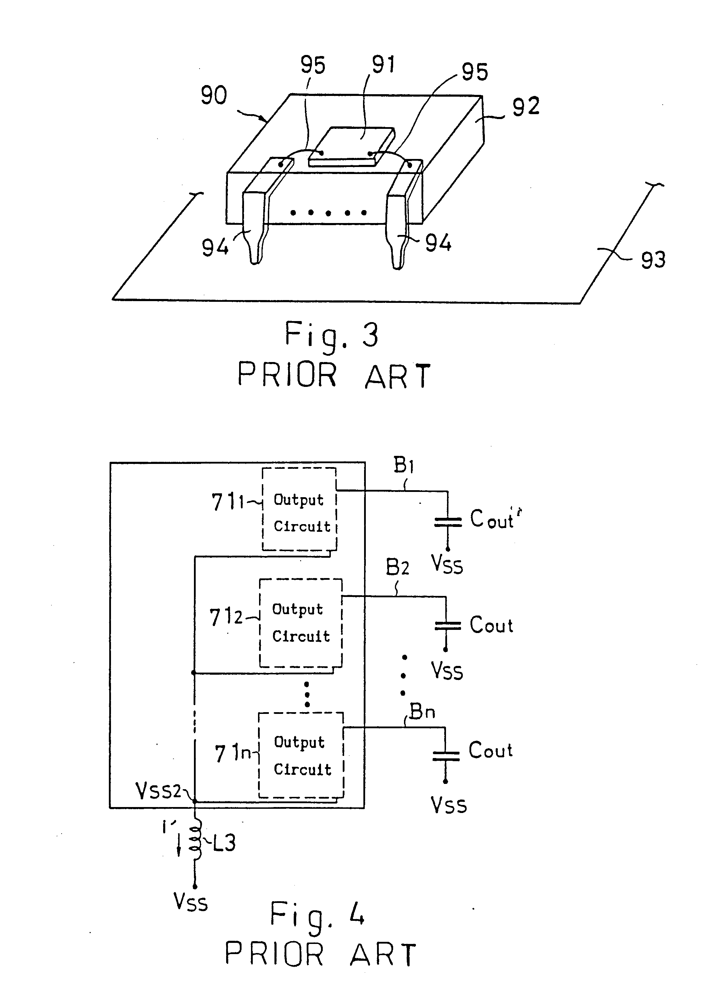

However, when di/dt is large in this way, the following problem arises. Normally, as shown in Figure 3, integrated circuit chip 91 is enclosed by package 92 to become integrated circuit drive 90. This device 90 is used by being mounted on system product circuit board 93. There are the lead pins 94 of device 90 and the bonding wires 95 between the $V_{DD}$ and $V_{SS}$ power source wires of circuit board 93 and the chip internal $V_{DD}$ and $V_{SS}$ power source wires, and there are inductors L1 and L2 of the order of 10nH on these. Consequently, when di/dt is large, a voltage L2'.di/dt (L2' is the industance of inductor L2) appears at both ends of inductor L2, and the chip internal $V_{SS1}$ potential rises above earth potential. In other words, it is known that power source wire noise occurs. On the other hand, for input circuit 72 of the integrated circuit, when the input voltage $V_{IN}$ is, for example, 2.5V, high logic level "1" must be sensed for the integrated circuit to be of TTL-compatible specification. However, when the chip internal $V_{SS1}$ potential rises by 2V, $V_{IN} - V_{SS1} = 0.5V$ becomes the voltage which is sensed by input circuit 72 and malfunction will occur since this is sensed as "0". Thus, the reliability of the integrated circuit operation will be reduced.

The cause of the above problem arising is mainly due to the large di/dt, in other words, it is caused by the changing of the potential of output wire B at high speed. If this variation were carried out slowly, the operation delay of the integrated circuit would naturally increase and would result in the loss of the high-speed characteristic.

In particular, in integrated circuits haivng multiple data output (e.g. memory integrated circuit which carry out read/write by character units), compared with the case of a single data output, as shown in Figure 4, there are output wires $B_1$, $\sim$ Bn, corresponding to each of the inividual output circuits $71_1$, $\sim$ $71_N$ and the discharge currents i' of each output capacitance $C_{out}$ flow in common to inductor L3 which is on the $V_{SS}$ power source side. Therefore, large noise signals occur due to the $V_{SS2}$ potential inside the chip and the problem mentioned above becomes more serious.

An object of this invention is to provide a semiconductor integrated circuit which has a combination of a high-speed characteristic, a low noise characteristic for the power source potential and a high reliability of integrated circuit performance, without reducing the usability through reduction of the output hold time.

This invention provides a semiconductor integrated circuit to be connected between the high and low potentials of a power source comprising, a data output buffer means having an output node for outputting data, a voltage limiting circuit means for limiting the potential of the output node to less than the high potential level.

When varying the data output from "1" to "0" by reducing the output wire to a set voltage in this way, it is possible to reduce the time variation of the discharge current of the output capacitance without loss of the high-speed output characteristic. Thus, the fluctuation (noise) of the chip internal $V_{SS}$ power source voltage becomes smaller, malfunctions of input circuits and the like are less likely to occur and the reliability of circuit performance becomes higher.

Embodiments of the invention will now be described by way of example only and with reference to the accompanying drawings, in which :-

Figure 1 is a circuit diagram showing part of a convcentional integrated circuit and its connection to another semiconductor device;

Figure 2 is a timing wave-form chart showing the output operation in the integrated circuit in Figure 1;

Figure 3 is a partial perspective oblique view showing in simplified form the mounting of an integrated circuit device on a circuit board;

Figure 4 is a circuit diagram showing part of an intergrated circuit which has several output buffers;

Figure 5 is a circuit diagram showing part of a semiconductor integrated circuit relating to an embodiment of this invention and its connection to another semiconductor device;

Figure 6 is a timing wave-form chart showing the output operation in the integrated circuit in Figure 5;

Figure 7 is a logic circuit diagram showing a specific example of a circuit for generating the switch drive signals in Figure 5;

Figure 8 is a circuit diagram showing another embodiment of the output buffer and voltage reduction circuits in Figure 5;

Figure 9 is a timing wave-form chart showing the operation of the circuits in Figure 8;

Figure 10 is a circuit diaram showing the output buffer and voltage reduction circuits relating to a further embodiment; and,

Figure 11 is a timing wave-form chart showing the operation of the circuits in Figure 10.

As explained above, it was difficult to achieve high-speed operation, a low noise characteristic for the power source potential and reliability of integrated circuit operation at the same time in the output circuit of a conventional integrated circuit. In order to solve this problem, reduction of the size of the variation of the output voltage by pre-charging or pre-discharging an output voltage of the order of 1V or 1.5V during the period from the integrated circuit being accessed to outputting can be considered. However, it this is done, since the logic level of the output voltage changes as soon as the integrated circuit is accessed, the output hold time $t_{OH}$ becomes very short, and therefore it is very inconvenient for the users to use since they have to read the output rapidly.

Moreover, the measure of reducing the variation of the output voltage by stopping a little above $V_{OH}$ without raising the output voltage to the $V_{DD}$ voltage when the output voltage is varied from "0" to "1" can also be considered. However, in cases when output wire B is shared by another circuit, no effect will be achieved by this measure if output wire B is raised to $V_{DD}$ potential by that other circuit.

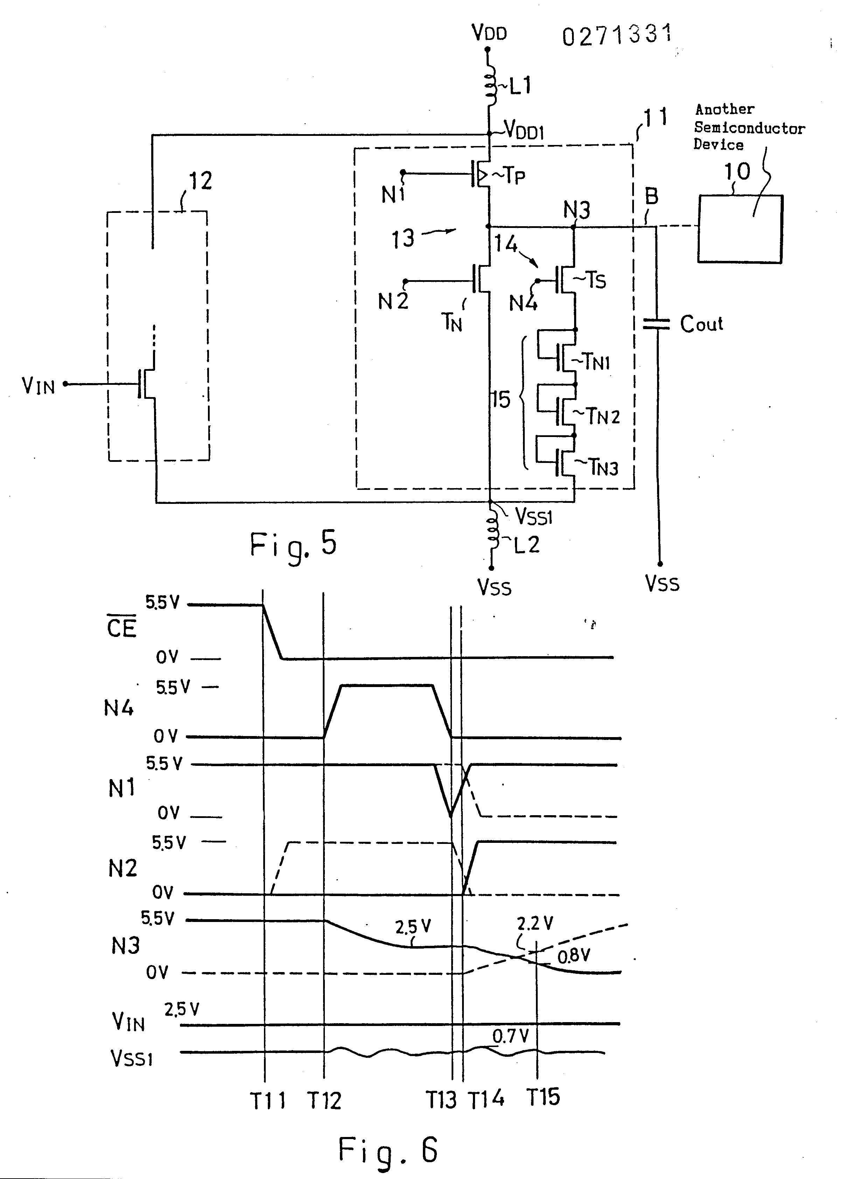

Figure 5 shows part of a semiconductor integrated circuit to TTL compatible specifications and 10 is another semiconductor device to which the output signal of this integrated circuit is inputted. In the integrated circuit, reference numeral 11 designated the output circuit and 12 is the input circuit. L1 designated an inductor between the $V_{DD}$ power source and the chip internal $V_{DD1}$ power source node. L2 designated an inductor between the $V_{SS}$ power source and the chip internal $V_{SS1}$ power source node. A final stage data output buffer 13 is connected by connecting a P-channel transistor $T_P$ and an N-channel transistor $T_N$ in series between $V_{DD1}$ power source node and $V_{SS1}$ power source node in output circuit 11. The output circuit is designed so that a different driving signal can be applied to each of the gates of these transistors (nodes N1 and N2). Also, a voltage limiting circuit 14 is connected between output node N3 of output buffer 13 (the mutual connection point of the drains of both transistors $T_P$ and $T_N$) and $V_{SS1}$ power source node. There is an output capacitance $C_{out}$ in output wire B which is connected to output node N3. Voltage limiting circuit 14 is composed of a constant-voltage circuit 15 and an N-channel switch transistor $T_S$. Constant-voltage circuit 15 is composed of several (3 in this embodiment) N-channel transistor $T_{N1}$, $T_{N2}$ and $T_{N3}$ in each of which the drain and gate are connected to each other. A switch drive signal is applied to the gate (node N4) of N-channel switch transistor Ts with a timing which is described later.

Next, the operation of the integrated circuit is explained with reference to Figure 6.

Suppose that, at time T11, the chip enable signal $\overline{CE}$ becomes active (low level) and the integrated circuit is accessed. First, the case of the output of output node N3 being driven from "1" to "0", as shown by the solid line in Figure 6, is explained. Between times T12 and T13, a pulse-like switch driving signal is supplied to node N4 and N-channel transsitor Ts switches ON. Since the three N-channel transistors $T_{N1}$, $T_{N2}$ and $TN_3$ of constant-voltage circuit 15 are diode-connected, a voltage (e.e. 2.5V) which is slightly higher than three times the threshold value of each one appears as the constant-voltage output. Then, the voltage of output node N3 gradually falls to 2.5V. Even when the output has become 2.5V, since it is still igher than the $V_{OH}$ potential, the other semiconductor device 10 senses it as "1".

Consequently, since the output is not varied at this time, the output hold time $t_{OH}$ is not worsened. Also, at time T14 when the actual data output commences, since the output voltage has already become 2.5V, simply by varying it by 1.7V from that value towards $V_{OL} = 0.8V$, the other semiconductor will sense it as "0" data having been outputted. Consequently, the output delay does not vary even when the output voltage is reduced slowly at a speed which is about 1/3 that of a conventional example. At this time, the rise of the chip internal $V_{SS1}$ power source node from OV occurring due to inductor L2 on $V_{SS1}$ power source wire, that is to say the generation of noise in the power source wire, is only about 0.7V. In this case, if the input voltage $V_{in}$ of input circuit 12 is 2.5V, the voltage sensed by the MOS transistor of input circuit 12 is 2.5V - 0.7V = 1.8V, and since this can be satisfactorily sensed as "1" (because it is significantly above 0.8V) there is little risk of malfunction.

Furthermore, at the time of the above operation, since it is possible to produce low consumption power by turning OFF P-channel transistor $T_P$ of output buffer 13 while voltage limiting circuit 14 is in the ON state without creating a through-current path between the power sources, the potential of node N1 is made "1" level between times T11 and T12 in this embodiment.

On the other hand, in the case of driving the output from "0" to "1", as shown by the dotted line in Figure 6, the output potential remains at OV until the actual output of data commences at time T14, and so the output hold time does not worsen. Also, if the output potential is varied towards $V_{OH} = 2.2V$ from time T14, the other semiconductor device 10 will sense that "1" data has been outputted.

When using the integrated circuit of this embodiment as decribed above, it is designed so that, if the potential of output wiring B is $V_{OH}$ or more during the period from the time of being accessed to the time data is outputted, this potential will be less than $V_{DD}$ and also it will be reduced to a potential above $V_{OH}$. Consequently, despite the fact that high-speed output is possible, the noise generated in the power source wire at the time of output is very small and malfunction in the integrated circuit caused by noise can be prevented. Also, when the integrated circuit has been accessed, since the logic output does not change immediately and previous data remains, there is no problem of the output hold time $t_{OH}$ becoming shorter, and thus there will not be any inconvenience for the user.

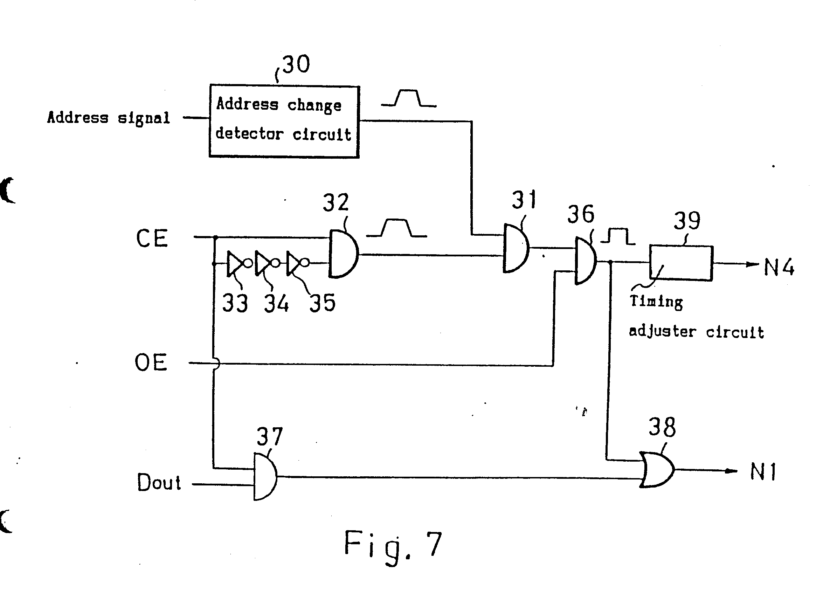

Next, as an example of the generating circuit for the switch driving signal in this embodiment, one which is provided, for example, in a memory integrated circuit which is accessed by the chip enable signal and uses an output enable signal OE is explained with reference to Figure 7. If it is a case of integrated circuit which does not use an address signal or an output enable signal OE, these signals may simply be fixed at "1" level. In Figure 7, reference numeral 30 designated an address change detector circuit which detcts when the address signal has changed and generates a positive pulse. This detection output becomes the input to one side of first AND gate 31. The CE signal, besides becoming the direct input to one side of second AND gate 32, becomes the input to the other side of second AND gate 32 after it has been delayed and inverted by passing through three stages of invertes 33, 34 and 35. The output of second AND gate 32 becomes the input to the other side of first AND gate 31. The output of first AND gate 31 and the OE signal become the inputs to third AND gate 36. The CE signal and the integrated circuit internal data signal $D_{out}$ become the inputs to fourth AND gate 37. The output of fourth AND gate 37 and the output of third AND gate 36 become the inputs to OR gate 38, and the output or OR gate 38 is applied to the gate of P-channel transistor $T_P$ of Figure 5 (node N1). Moreover, the output of third AND gate 36 is adjusted to a suitable timing by timing adjuster circuit 39 and is applied as the switch driving signal to node N4 of voltage limiting circuit 14.

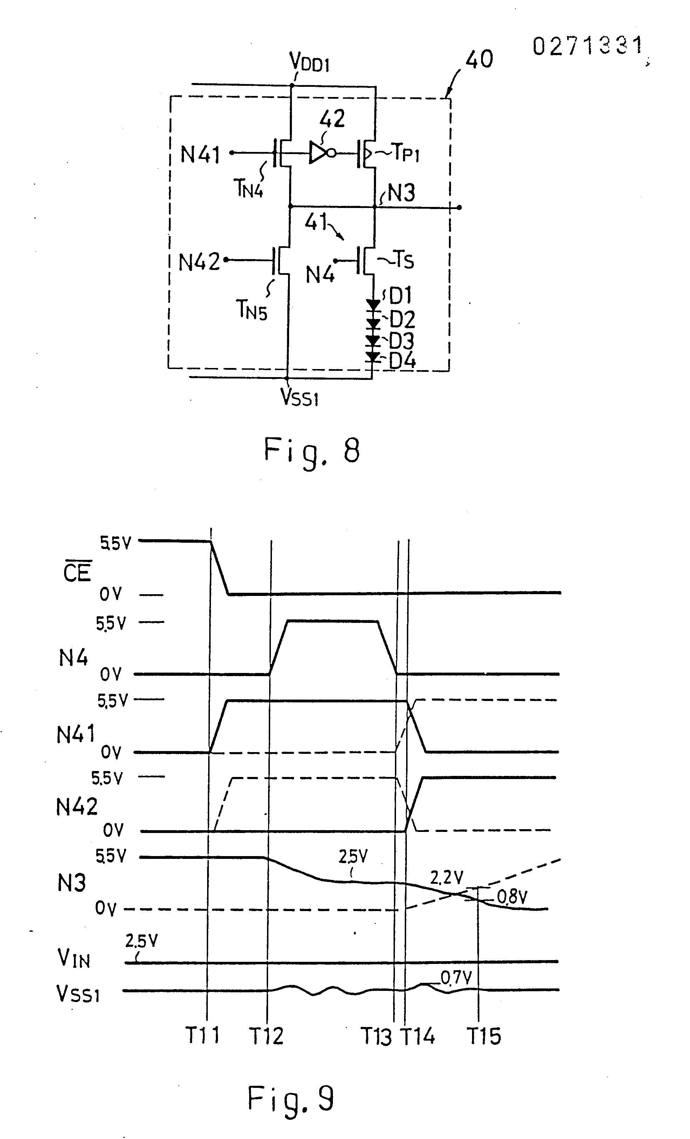

Figure 8 shows output circuit 40 relating to another embodiment of this invention. As the pull-up side transistors of the final state output buffer, N-channel transistor $T_{N4}$ (its gate is connected to node N41) which has a large driving power and P-channel transistor $T_{p1}$ which has a small driving power are conencted in parallel. As the pull-down side transitor, N-channel transistor $T_{N5}$ (its gate is connected to node N42) which has a large driving power is used. Voltage limiting circuit 41, which is connected to output node N3, is composed of a switch N-channel transistor $T_S$ and four diodes D1 to D4 connected in series for constant-voltage generation. Inverter 42 is inserted between the gate of N-channel transistor $T_{N4}$ and the gate of P-channel transistor $T_{P1}$.

For the output circuit in Figure 8, the operation when the output changes from "1" to "0" and the operation when it changes from "0" to "1" are shown by the solid line and the dotted line in Figure 9. In this circuit, in the case of changing the output from "1" to "0", a pulse signal which becomes "1" level is applied to node 41 during the period from being access to outputting data (from time T11 to time T14). Consequently, during the period of this pulse signal N-channel transitor $T_{N4}$ and P-channel transistor $T_{P1}$are turned ON, but N-channel transistor $T_{N4}$ only raises the output potential to above $V_{DD} - V_{th,} = 3.5V$. Here $V_{th,}$ is the threshold voltage which has received the substrate bias effect of N-channel transistor $T_{N4}$. Consequently, since hardly any through current occurs between the power sources, even though N-channel transistor $T_{N4}$ and switch transistor $T_S$ of voltage limiting circuit 41 are ON at the same time, pull-up N-channel transistor $T_{N4}$ need not always be turned OFF when switch transistor $T_S$ is turned ON. Designing the timing of the gate potential control of the pull-up transistor will be less difficult. Pull-up P-channel transistor $T_{P1}$ has the function of raising the output from 3.5V to $V_{DD}$ potential, and by this means it prevents a through current path occurring between power sources in the input circuit of the other semiconductor device (10 in Figure 5) at stand-by time.

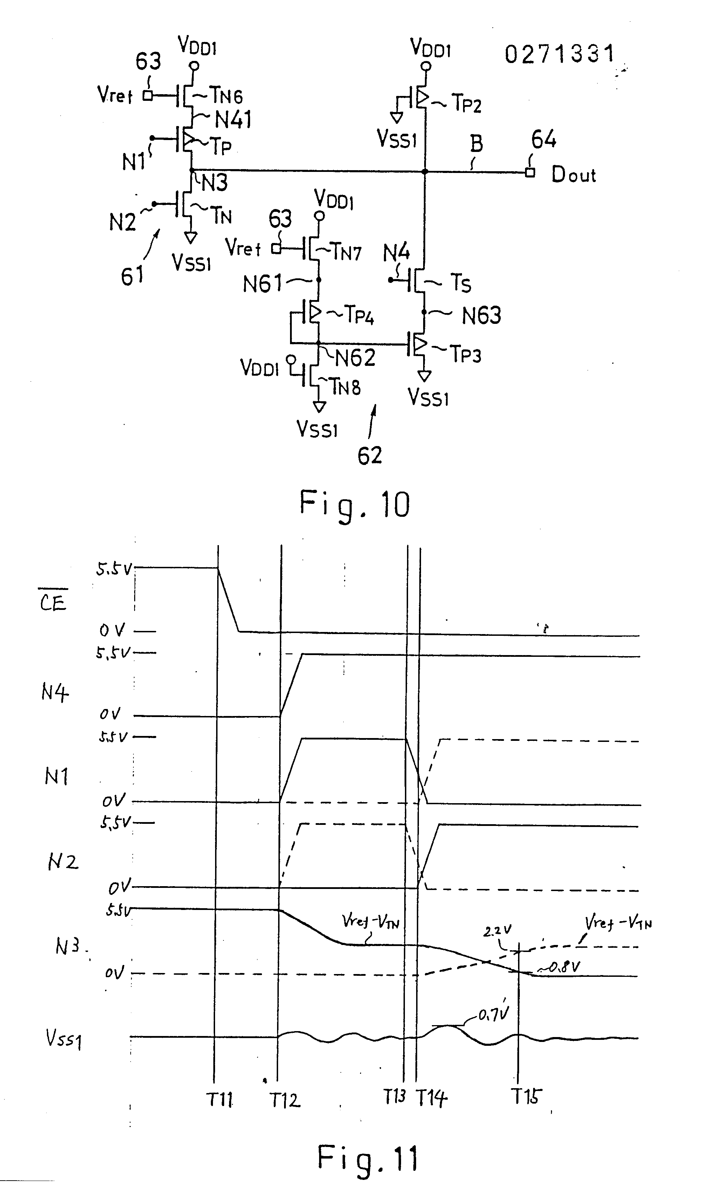

Figure 10 shows the output circuit relating to a further embodiment. Final stage output buffer 61 is of NMOS construction, and voltage limiting circuit 62 is connected to its output node N3. A normally ON type P-channel transistor $T_{P2}$, the gate of which is connected to the chip internal $V_{SS1}$ power source node, is connected between the chip internal $V_{DD1}$ power source node and output node N3. For final state output buffer 61, pull-up N-channel transistor $T_N$ is connected between the source of pull-up P-channel transistor $T_P$ and the $V_{SS1}$ power source node, and N-channel transistor $T_{N6}$, to the gate of which a specified reference voltage $V_{ref}$ from pad 63 is applied, is inserted between the drain of pull-up transistor $T_P$ and the $V_{DD1}$ power source node.

Moreover, in voltage limiting circuit 62, a switch N-channel transistor $T_S$ and P-channel transistor $T_{P3}$are connected in series between output node N3 and the $V_{SS1}$ power source node. Also, N-channel transistor $T_{N7}$, to the gate of which reference voltage $V_{ref}$ is applied, P-channel transistor $T_{P4}$, the gate and drain on which are connected together, and N-channel transistor $T_{N8}$, the gate of which is connected to $V_{DD1}$ power source node, are connected in series between $V_{DD1}$power source node and $V_{SS1}$ power source node. The drain of N-channel transistor $T_{N8}$ is connected to the gate of P-channel transistor $T_{P3}$. Reference numeral 64 designated an output pad and $D_{out}$ is the data output. N1, N2 and N4 are the same nodes as in Figure 5.

Next, the operation of the above circuit is explained. In voltage limiting circuit 62, if the ON resistance of N-channel transistor $T_{N7}$ is set considerably lower than the ON resistance of N-channel transistor $T_{N8}$, the source (node N61) voltage of transistor $T_{N7}$ will be set a $V_{ref} - V_{TN}$ ($V_{TN}$ is the threshold value of an N-channel transistor). If the ON resistance of P-channel transistor $T_{P4}$ is also set considerably lower than the ON resistance of N-channel transistor $T_{N8}$ the drain (node N62) voltage of transistor $T_{P4}$ will be set at $V_{ref} - V_{TN} + V_{TP}$($V_{TP}$ is the threshold value of a P-channel transitor ). Since P-channel transistor $T_{P3}$, to the gate of which this voltage is applied, becomes in the ON state when the potential of its course (node N63) is higher than $V_{ref} - V_{TN}$, if switch transitor $T_S$ is switch driven and becomes in the ON state when the output is changed from "1" to "0", until the voltage of its source (node N63) reduces to $V_{ref} - V_{TN}$, P-channel transistor $T_{P3}$ will become in the ON state and a current will flow. Then, if the voltage of node N63 becomes lower than $V_{ref} - V_{TN}$, P-channel transistor $T_{P3}$ will turn OFF and the voltage of node N63 will not alter. Consequently, by setting the reference voltage $V_{ref}$ the output voltage can be set to a specified value above $V_{OH}$ which will cause it to reduce below $V_{DD}$ voltage prior to changing form "1" to "0" and outputting of data "0". Also, since N-channel transistor $T_{N6}$ is inserted in output buffer 61, the high logic level of the output voltage can be made the same as the set voltage by voltage limiting ciruit 62, and the occurrence of a through current flowing from output buffer 61 through limiting circuit 62 can be prevented. Moreover, in the case of output buffer 61 not being driven for a long time, it is desirable to prevent the occurrence of a through current in the other semiconductor device (10 in Figure 5) and to reduce the consumption current by setting output wiring B at MOS level. For this reason, P-channel transistor $T_{P2}$which is normally ON, is provided.

Next, the operation of the integrated circuit is explained with reference to Figure 11.

Suppose that, at time T11, the chip enable signal $\overline{CE}$ becomes active (low level) and the integrated circuit is accessed. First, the cost of the output of output node N3 being driven from "1" to "0", as shown by the solid line in Figure 11, is explained. After time T12, node N4 becomes "1" and N-channel transistor $T_S$ switches ON. The transistors $T_{N7}$, $T_{P4}$ and $T_{N8}$ are bias circuits. The voltage of node $N_{61}$ is set at $V_{ref} - V_{TN}$ ($V_{TN}$ is the threshold of an N-channel transistor) and the voltage of node N62 is set at $V_{ref} - V_{TN} + V_{TP}$ ($V_{TP}$ is the threshold value of a P-channel transistor). Since the gate voltage of P-channel transistor $T_{P3}$ is $V_{ref} - V_{TN} + V_{TP}$, P-channel transistor $T_{P3}$ becomes in the ON state when the voltage of node N63 is higher than $V_{ref} - V_{TN}$. Consequently, the voltage of output node N3 reduces to $V_{ref} - V_{TN}$. If the value of $V_{ref} - V_{TN}$ is set to the value above the $V_{OH}$ potential, the other semiconductor device (10 in Figure 5) sences it as "1". Since the output is not varied at this time, the output hold time $T_{OH}$ is not worsened. Also, at time T14 when the actual data output commences, since the voltage of node N63 is lower than $V_{ref} - V_{TN}$ in case of outputting "0" level, P-channel transistor $T_{P3}$ is in the OFF state. Since the gate voltage of N-channel transistor $T_{N6}$ is set at $V_{ref}$ in case of outputting "1", the output level of "1" is $V_{ref} - V_{TN}$ and P-channel transistor $T_{P3}$ is in the OFF state.

Consequently, even when N-channel transistor $T_S$becomes in the ON state, since there is no current flow from output buffer 61 through transistors $T_S$ and $T_{P3}$, the potential of node N4 can be held in the ON state. The high logic level of the otuput can be set by the $V_{ref}$ potential so as to achieve the smallest noise on the power source wires.

By using the semiconductor integrated circuit of this invention as described above, there will be high-speed output capability, low power source voltage noise when outputting and high reliability of circuit operation, and there will be no reduction of output hold time and thus no inconvenience for the user.

Furthermore the embodiment as described above can be used in the semiconductor integrated circuit includes a number of the data output buffers.

Consequently, the application of this invention to such devices as semiconductor memories in which high-speed access is required and logic type integrated circuit which have large numbers of output pins is extremely effective.

Various modification can be made to the above described embodiments without departing from the scope of the invention.

## Claims

1. A semiconductor integrated circuit to be connected between the high and low potentials ($V_{DD}$, $V_{SS}$) of a power source, comprising :
a data output buffer means (13) having an output node (N3) for outputting data; characterised by
a voltage limiting circuit means (14) for limiting the potential of the output node (N3) to less than the high potential level.

2. A semiconductor integrated circuit as claimed in claim 1, further characterised in that the data output buffer means (13) includes a pull-up transistor ($T_P$), which is arranged to be in the OFF state when the potential of the output node (N3) is limited by the voltage limiting circuit means (14).

3. A semiconductor integrated circuit as claimed in claim 1 or 2, further characterised in that the voltage limiting circuit means (14) limits the output potential to a predetermined potential which is set by means of a reference voltage ($V_{ref}$).

4. A semiconductor integrated circuit as claimed in any preceding claim further characterised in that the voltage limiting circuit (14) includes a switch transistor ($T_S$) and a constant voltage circuit (15).

5. A semiconductor integrated circuit as claimed in claim 4, further characterised in that the constant voltage circuit (15) includes a plurality of a transistor in each of which the drain and gate are connected to each other.

6. A semiconductor integrated circuit as claimed in claim 4, further characterised in that the constant voltage circuit (15) includes a plurality of diodes (D1 ~ D4) connected in series.

7. A semiconductor integrated circuit as claimed in claim 2 or 4, in combination with a signal generating means including an address change detection circuit (3) and coupled to the data output buffer means (13) and the voltage limiting circuit means (14) for generating the switch driving signals corresponding to an address signal and a chip enable signal (CE).

8. A semiconductor integrated circuit as claimed in claim 4, further characterised in that the data output buffer means (61) includes a transistor means ($T_{N6}$) coupled between the high potential ($V_{DD}$) and the pull-up transistor ($T_P$) for preventing the occurrence of a through current flowing form the data output buffer means (61) through the voltage limiting circuit means (62)

9. A semiconductor integrated circuit as claimed in claim 4, further characterised in that the constant voltage circuit (62) includes a first P-channel transistor ($T_{P3}$) coupled between the switch transistor ($T_S$) and the low level potential, a first N-channel transistor ($T_{N8}$), the drain of which is connected to the gate of P-channel transistor ($T_{P3}$), a second P-channel transistor ($T_{P4}$), the gate and the drain of which are connected together and to the gate of P-channel transistor ($T_{P3}$), and a second N-channel transistor ($T_{N7}$), coupled between the high level potential and the second P-channel transistor ($T_{P4}$), the gate of which is connected to a reference potential ($V_{ref}$).

10. A semiconductor integrated circuit as claimed in any preceding claim, further characterised in that the semiconductor integrated circuit includes a number of the data output buffers means.

Fig.1
PRIOR ART

Fig. 2
PRIOR ART

0271331

Fig. 3
PRIOR ART

Fig. 4
PRIOR ART

Fig. 5

Fig. 6

0271331

Fig. 7

0271331

Fig. 8

Fig. 9

Fig. 10

Fig. 11